# EUROPEAN PATENT APPLICATION

(11) **EP 4 580 008 A1**
(43) Date of publication of application: **02.07.2025**
(21) Application number: 24222153.9
(22) Date of filing: 20.12.2024
(51) Int. Cl.: H02K 3/50, H02K 5/22, H02K 9/19

(54) **CONNECTOR ASSEMBLY, ELECTRIC DRIVE SYSTEM AND VEHICLE**

(30) Priority: 29.12.2023 CN 202311852134
(71) Applicant: Valeo eAutomotive Germany GmbH, 91056 Erlangen (DE)
(72) Inventor: DENG, Xiaoxue, 91056 Erlangen (DE); LI, Zion-Yue, 91056 Erlangen (DE); ZHAO, Wanchao, 91056 Erlangen (DE); CHU, Zhichao, 91056 Erlangen (DE); FENG, Lefan, 91056 Erlangen (DE); ZHANG, Joshua-Shu, 91056 Erlangen (DE); CHEN, Xucan, 91056 Erlangen (DE); GU, Yifan, 91056 Erlangen (DE); JIN, Yejin, 91056 Erlangen (DE)
(74) Representative: Valeo Powertrain Systems

(57) **Abstract**

The present disclosure relates to a connector assembly for an electric drive system, an electric drive system and a vehicle. The connector assembly comprises: multiple busbars, each of the multiple busbars having a first part extending in a first direction and an electric connection terminal; a first insulating component, the first parts of the multiple busbars being at least partially arranged in the first insulating component in a mutually insulated manner; and a fluid channel, arranged on the first insulating component and capable of guiding a cooling fluid from a cooling system of the electric drive system.

## Description

### Technical Field

The present disclosure relates to a connector assembly, an electric drive system and a vehicle.

### Background

Existing electric drive systems for motor vehicles are generally equipped with a special cooling system for cooling an electric motor in the electric drive system. In general, the cooling system may cool the electric motor using oil used to lubricate a speed reducer. However, existing cooling systems lack direct cooling for electric connectors; most coolants cannot come into direct contact with electric connectors, especially connection terminals thereof which produce a lot of heat, and for this reason, the system cooling efficiency is not high.

In addition, oil is needed to lubricate the meshing region of gears in the speed reducer, but lubricating oil in known electric drive systems cannot flow directly to the gear meshing region, and consequently, lubricating efficiency is also not high.

Thus, there is a need in the art for a connector assembly and an electric drive system that are capable of solving the abovementioned problems.

### Summary of the Invention

The present disclosure relates to a connector assembly for an electric drive system, the connector assembly comprising: multiple busbars, each of the multiple busbars having a first part extending in a first direction and an electric connection terminal; a first insulating component, the first parts of the multiple busbars being at least partially arranged in the first insulating component in a mutually insulated manner; and a fluid channel, arranged on the first insulating component and capable of guiding a cooling fluid from a cooling system of the electric drive system.

Conduction, cooling and lubrication functions can be integrated on a single component by integrating the fluid channel on the connector assembly, thus improving cooling efficiency and lubricating efficiency, in a structurally simple and highly flexible way.

The connector assembly according to the present disclosure may also have one or more of the following features individually or in combination.

In an embodiment, the connector assembly further comprises multiple first outlet flow channels, which are arranged on the first insulating component and in fluid communication with the fluid channel, and able to guide the cooling fluid to a speed reducer cavity of the electric drive system, so as to perform lubrication and/or cooling. In this way, cooling efficiency and lubricating efficiency can be improved.

In an embodiment, the connector assembly further comprises multiple second outlet flow channels, which are arranged on the first insulating component and in fluid communication with the fluid channel, and able to guide the cooling fluid to positions where the electric connection terminals are connected to stator terminals of the electric drive system. Since the positions where the electric connection terminals of the busbars are connected to the stator terminals of the electric drive system are at a higher temperature within the system, this solution of the present disclosure whereby cooling fluid is guided directly to the positions of connection can significantly improve cooling efficiency.

In an embodiment, the fluid channel extends in the first direction.

In an embodiment, each of the multiple first outlet flow channels is configured to guide the cooling fluid to flow towards a gear meshing region of a speed reducer of the electric drive system. In this way, cooling fluid can drip directly into the gear meshing region, not only being able to lubricate the gear meshing region directly, but also being able to cool the gear meshing region directly; consequently, the cooling efficiency and lubricating efficiency are higher, thus reducing the amount of cooling fluid required.

In an embodiment, the connector assembly further comprises guide tubes, which are connected to the corresponding first outlet flow channels and extend to the gear meshing region. This setup further reduces wastage of cooling fluid, further improving cooling efficiency and lubricating efficiency.

In an embodiment, the connector assembly further comprises a fluid inlet arranged on the first insulating component. This setup can make the system more compact in volume.

In an embodiment, the fluid channel comprises, in the first direction, a first portion, a second portion, and a ramp portion between the first portion and the second portion. In this way, the fluid flow speed can be adjusted; different requirements can thus be met, with higher system flexibility.

In an embodiment, the fluid channel comprises a first fluid sub-channel and a second fluid sub-channel which are separated from one another by a dividing member; the first fluid sub-channel is in communication with the first outlet flow channels, and the second fluid sub-channel is in communication with the second outlet flow channels.

In an embodiment, the dividing member is a rib oriented in the first direction.

Separating the cooling fluid flowing to the first outlet flow channels and the cooling fluid flowing to the second outlet flow channels allows different fluid flow speeds to be achieved, so as to adapt to different requirements, thus making the connector assembly and the electric drive system more flexible.

In an embodiment, the first insulating component is provided with multiple busbar channels which are separate from one another, the multiple busbar channels being stacked parallel to each other. This setup can ensure that the multiple busbars are insulated with respect to each other, and can also reduce the volume of the connector assembly, thereby reducing the volume of the electric drive system.

In an embodiment, the fluid channel is arranged above the multiple busbar channels. This design reduces the volume of a single component integrating conduction, cooling and lubrication functions, making the structure thereof more compact.

In an embodiment, each of the multiple busbars also has a second part extending in a second direction different from the first direction; the connector assembly further comprises a second insulating component connected to the first insulating component, and the second parts of the multiple busbars are at least partially arranged in the second insulating component in a mutually insulated manner; and the connector assembly further comprises a sealing member, which is arranged on the second insulating component near the junction of the first insulating component and the second insulating component. In addition to a sealing function, the sealing member may also serve a guiding function, so as to indicate an installation direction to an operator when the connector assembly is being installed.

The present disclosure further provides an electric drive system, comprising the connector assembly described above.

The present disclosure further provides an electric drive system, comprising: a speed reducer cavity; a controller cavity; and the connector described above, wherein the sealing member seals the controller cavity with respect to the speed reducer cavity.

The present disclosure further provides a vehicle, comprising the electric drive system described above.

### Brief Description of the Drawings

A better understanding of the advantages and objective of the present disclosure can be gained from the preferred embodiments of the present disclosure described in detail below with reference to the drawings. To better illustrate the relationships among components in the drawings, the drawings are not drawn to scale. In the drawings:
Fig. 1 shows a partial schematic drawing of an electric drive system for a vehicle according to an embodiment of the present disclosure;
Fig. 2 shows a partial schematic drawing of the interior of an electric drive system for a vehicle according to an embodiment of the present disclosure;
Fig. 3 shows a schematic drawing of a connector assembly of an electric drive system according to an embodiment of the present disclosure;
Fig. 4 shows a schematic drawing of the connector assembly according to Fig. 3, from another direction;
Fig. 5 shows a schematic drawing of a fluid channel of the connector assembly according to Fig. 3;
Fig. 6 shows a schematic drawing of busbar channels of the connector assembly according to Fig. 3;
Fig. 7 shows a schematic drawing of the busbar channels of the connector assembly according to Fig. 6, from another direction; and
Fig. 8 shows a schematic drawing of a connector assembly of an electric drive system according to another embodiment of the present disclosure.

### Detailed Description of the Invention

To clarify the technical solution and advantages of the present disclosure, as well as the object of this technical solution, the technical solutions of embodiments of the present disclosure are described clearly and completely below in conjunction with the drawings of specific embodiments of the present disclosure. In the drawings, identical reference numerals denote identical components. It should be explained that the embodiments described are some, not all, of the embodiments of the present disclosure. All other embodiments obtained by those skilled in the art on the basis of the described embodiments of the present disclosure without inventive effort shall fall within the scope of protection of the present disclosure.

Unless otherwise defined, the technical or scientific terms used herein shall have the common meanings understood by those skilled in the art. The words "first", "second", and the like used in the description and claims of the patent application disclosed herein do not indicate any order, quantity or importance, being merely used to distinguish different component parts. Likewise, words such as "a" or "one" do not necessarily represent a quantity limit. Words such as "comprising", "including" or "having" mean that the element or object preceding the word covers the elements or objects listed after the word and equivalents thereof, without excluding other elements or objects. Words such as "connection" or "communication", rather than being limited to the physical or mechanical connection or communication shown in a drawing, may include connection or communication equivalent thereto, irrespective of whether it is direct or indirect. The terms "upper", "lower", "left", "right" and the like are only used to indicate a relative positional relationship, and when the absolute position of a described object changes, the relative positional relationship may also change accordingly.

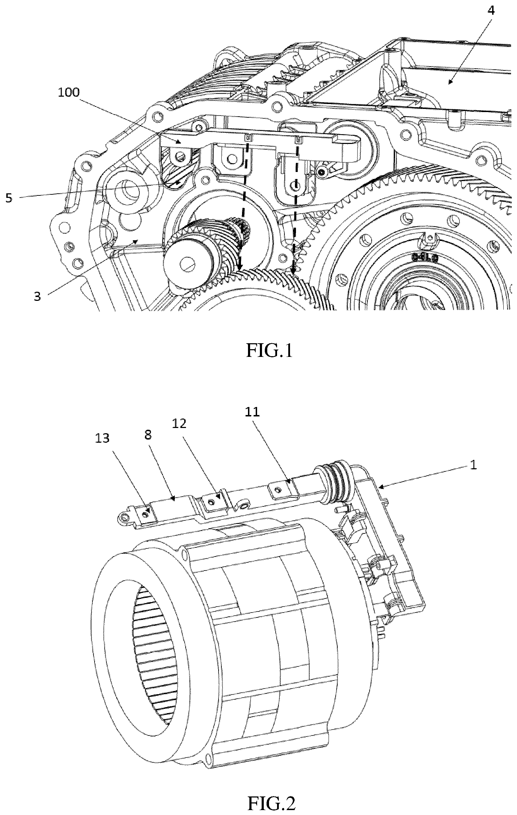

Embodiments of the present disclosure are described in detail below with reference to Figs. 1 - 8.

Fig. 1 shows part of an electric drive system for a vehicle according to an embodiment of the present disclosure, the electric drive system comprising a housing, the housing forming a speed reducer cavity 3, a controller cavity 4 and an electric motor cavity 5. In some embodiments, the housing may be a one-piece housing, or may be assembled from two or more housing components by fastening, welding or another connection method. The speed reducer cavity 5 is arranged at an end of the housing and may be closed by an additional cover, and contains lubricating oil and components including a speed reducer. The controller cavity 4 is arranged at the top of the housing, and contains a controller such as an inverter. The electric motor cavity 5 is formed by a main body or main part of the housing, and contains an electric motor. The electric motor comprises a stator, and a rotor located within the stator. The rotor comprises a rotary shaft capable of rotation, and a rotor core that is arranged on the rotary shaft and composed of multiple metal laminations (e.g. silicon steel plates); the stator comprises a stator core composed of multiple metal laminations (e.g. silicon steel plates), and windings arranged thereon. The stator core has a roughly tubular structure, with the rotor accommodated therein. The windings are able to generate a rotating magnetic field when supplied with three-phase alternating current, thereby generating electromagnetic torque to drive the rotor to rotate. The windings may be embedded in slots of the stator according to a certain pattern, and form a bun part at an end of the stator. In addition, the stator comprises stator outlet terminals, at which the windings of the stator may be electrically connected to an external electrical component. As shown in Figure 1, the stator is electrically connected to the controller in the controller cavity 4 via a connector assembly 100 of the electric drive system.

As shown in Figures 2 to 5, the connector assembly 100 of the electric drive system comprises multiple busbars 11, 12, 13, which are stacked on one another, enabling a reduction in the amount of space occupied. The busbars 11, 12, 13 are three-phase copper bars, specifically a U-phase copper bar, a V-phase copper bar and a W-phase copper bar, respectively. In addition, the connector assembly 100 further comprises a first insulating component 1 and a fluid channel 2. The fluid channel 2 is arranged on the first insulating component 1, and capable of guiding a cooling fluid from a cooling system of the electric drive system. For example, the cooling fluid may be oil from the speed reducer.

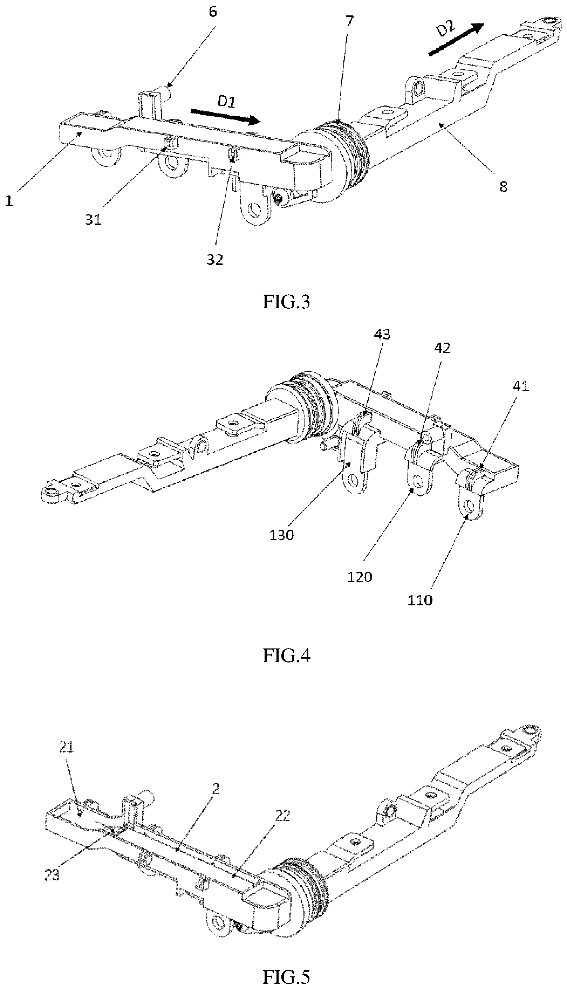

As shown in Figs. 3 and 4, each of the multiple busbars 11, 12, 13 has a first part extending in a first direction D1, and an electric connection terminal 110, 120, 130. The first parts of the multiple busbars 11, 12, 13 are at least partially arranged in the first insulating component 1 in a mutually insulated manner. For example, the first parts of the multiple busbars 11, 12, 13 are completely arranged in the first insulating component 1. The electric connection terminal 110 is arranged at an extremity of the busbar 11, the electric connection terminal 120 is arranged at an extremity of the busbar 12, and the electric connection terminal 130 is arranged at an extremity of the busbar 13. The electric connection terminals 110, 120, 130 are electrically connected to the stator outlet terminals in the electric motor cavity 5 separately.

Conduction, cooling and lubrication functions can be integrated on a single component by integrating the fluid channel on the connector assembly, thus improving cooling efficiency and lubricating efficiency, in a structurally simple and highly flexible way.

As shown in Figs. 3 and 4, each of the multiple busbars 11, 12, 13 also has a second part extending in a second direction D2 different from the first direction D1. For example, the first direction D1 may be perpendicular to the second direction D2, but the present disclosure is not limited to this, and the two directions can vary depending on the actual situation. As shown in Fig. 2, the connector assembly 100 further comprises a second insulating component 8 connected to the first insulating component 1, and the second parts of the multiple busbars 11, 12, 13 are at least partially arranged in the second insulating component 8 in a mutually insulated manner. For example, the second parts of the multiple busbars 11, 12, 13 are completely arranged in the second insulating component 8. Similar to the electric connection terminals 110, 120, 130, the multiple busbars 11, 12, 13 also have additional electric connection terminals at extremities of the second parts, these additional electric connection terminals being electrically connected to the controller in the controller cavity 4.

The first insulating component 1 and the second insulating component 8 are overmoulded on the multiple busbars 11, 12, 13, and may be a one-piece member.

In an embodiment of the electric drive system of the present disclosure comprising the speed reducer cavity 3, the controller cavity 4 and the connector assembly 100, the connector assembly 100 may further comprise a sealing member 7, the sealing member 7 being arranged on the second insulating component 8 near the junction of the first insulating component 1 and the second insulating component 8. The sealing member 7 seals the controller cavity 4 with respect to the speed reducer cavity 3. For example, the sealing member 7 is an O-ring. For example, the sealing member 7 is fitted round an outer surface of the second insulating component 8. As shown in Fig. 1, a portion of the sealing member 7 is installed in the controller cavity 4, and a portion is installed in the speed reducer cavity 3. In addition to a sealing function, the sealing member 7 may also serve a guiding function, so as to indicate an installation direction to an operator when the connector assembly is being installed.

As shown in Figs. 3 and 5, the connector assembly further comprises multiple first outlet flow channels 31, 32, the first outlet flow channels 31, 32 being arranged on the first insulating component 1 and in fluid communication with the fluid channel 2, and being able to guide cooling fluid to the speed reducer cavity 3 of the electric drive system, so as to perform lubrication or cooling. As shown by the dotted lines in Fig. 1, each of the multiple first outlet flow channels 31, 32 is configured to guide cooling fluid to flow towards a gear meshing region of the speed reducer of the electric drive system. The number of first outlet flow channels 31, 32 may be two; this depends on the number of gear meshing regions to be lubricated. Of course, other numbers are also possible, e.g. three or more. For example, each of the first outlet flow channels 31, 32 may have a square or round cross-sectional shape. In this way, cooling fluid can drip directly into the gear meshing region, not only being able to lubricate the gear meshing region directly, but also being able to cool the gear meshing region directly when needed; consequently, the cooling efficiency and lubricating efficiency are higher, thus reducing the amount of cooling fluid required.

In other examples, the connector assembly 100 further comprises guide tubes which are not shown in the figures, the guide tubes being connected to the corresponding first outlet flow channels 31, 32 and extending to the gear meshing region of the speed reducer. For example, the guide tube may extend along the dotted lines in Figure 1 to the gear meshing region. This setup further reduces wastage of cooling fluid, further improving cooling efficiency and lubricating efficiency.

As shown in Fig. 4, the connector assembly 100 further comprises multiple second outlet flow channels 41, 42, 43, the second outlet flow channels 41, 42, 43 being arranged on the first insulating component 1 and in fluid communication with the fluid channel 2, and being able to guide cooling fluid to the positions where the electric connection terminals 110, 120, 130 are connected to stator terminals (i.e. the abovementioned stator outlet terminals) of the electric drive system, as shown in Fig. 2. The number of second outlet flow channels 41, 42, 43 may be three; this depends on the number of electric connection positions to be cooled. Of course, other numbers are also possible, e.g. four or more. For example, each of the second outlet flow channels 41, 42, 43 may have a square or round cross-sectional shape. The cooling fluid flowing out of the second outlet flow channels 41, 42, 43 can flow to the abovementioned positions of connection under the action of gravity, and then partly flow into the electric motor cavity 5. The second outlet flow channels 41, 42, 43 may extend a certain distance, to guide cooling fluid to positions nearer the electric connection terminals 110, 120, 130. Since the positions where the electric connection terminals of the busbars are connected to the stator terminals of the electric drive system are at a higher temperature within the system, this solution of the present disclosure whereby cooling fluid is guided directly to the positions of connection can significantly improve cooling efficiency.

For example, the first outlet flow channels 31, 32 are arranged at the side of the connector assembly 100 that is located in the speed reducer cavity 3, and the second outlet flow channels 41, 42, 43 are arranged at the side of the connector assembly 100 that faces towards the electric motor cavity 5, and are opposite the first outlet flow channels 31, 32. This setup can reduce the volume, and is structurally simple.

As shown in Fig. 3, the connector assembly 100 further comprises a fluid inlet 6, the fluid inlet 6 being arranged on the first insulating component 1. The fluid inlet 6 may be connected to a cooling channel on the housing of the electric drive system, and cooling fluid from the electric drive system may be pumped into the fluid channel 2 from the fluid inlet 6 by a pump. This setup can make the system more compact in volume.

In Fig. 5, a cover plate of the first insulating component 1 has been removed to reveal the fluid channel; as this schematic drawing shows, the fluid channel 2 extends in the first direction D1. The fluid channel 2 comprises, in the first direction D1, a first portion 21, a second portion 22, and a ramp portion 23 between the first portion 21 and the second portion 22. The ramp portion 23 extends obliquely downwards in the opposite direction to the first direction D1. The ramp portion 23 can accelerate the flow of cooling fluid from the fluid inlet 6 to the first portion 21, and then to the electric connection terminal 110. Of course, the second portion 22 could also slope downwards in the first direction D1, to accelerate the flow of cooling fluid to the electric connection terminals 120 and 130. In this way, the fluid flow speed can be adjusted; different requirements can thus be met, with higher system flexibility.

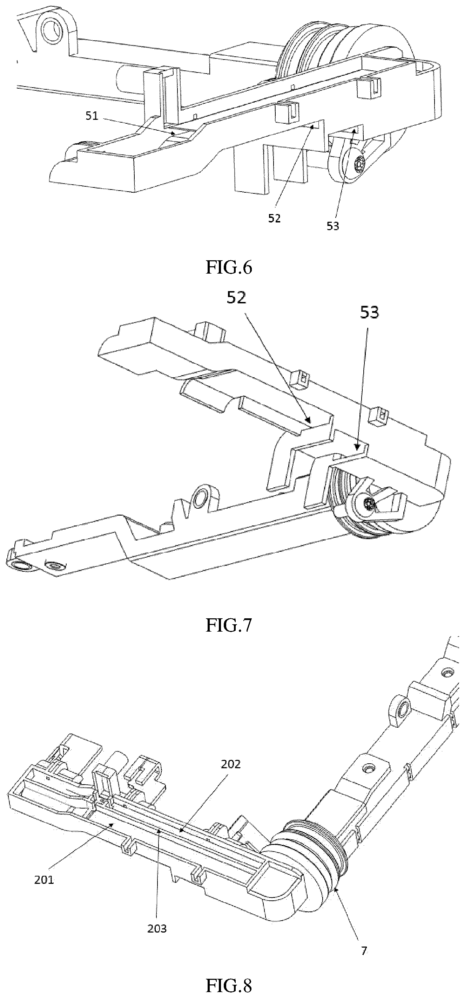

As shown in Figs. 6 and 7, the first insulating component 1 is provided with multiple busbar channels 51, 52, 53 which are separate from one another, the multiple busbar channels being stacked parallel to each other. For example, the multiple busbar channels 51, 52, 53 may be stacked in a direction perpendicular to the first direction D1 (i.e. the vertically upward direction in Fig. 6); that is, in the direction perpendicular to the first direction D1, the busbar channel 51 is uppermost, the busbar channel 52 is in the middle, and the busbar channel 53 is lowermost. The multiple busbar channels 51, 52, 53 are used for the busbars 11, 12, 13 respectively, and separated from one another by dividing walls on the first insulating component 1. Similarly, the second insulating component 8 is also provided with multiple busbar channels which are separate from one another and stacked in parallel; these are respectively connected to the busbar channels 51, 52, 53 of the first insulating component 1, for the busbars 11, 12, 13 to respectively pass through. The busbar channels stacked parallel to each other can ensure that the multiple busbars are insulated with respect to each other, and can also reduce the volume of the connector assembly, thereby reducing the volume of the electric drive system.

It can be seen from Fig. 5 that the fluid channel 2 is arranged above the multiple busbar channels 51, 52, 53. For example, the fluid channel 2 is arranged above and adjacent to the uppermost busbar channel 51. This design reduces the volume of a single component integrating conduction, cooling and lubrication functions, making the structure thereof more compact.

As shown in Fig. 8, the fluid channel 2 comprises a first fluid sub-channel 201 and a second fluid sub-channel 202 which are separated from one another by a dividing member 203; the first fluid sub-channel 201 is connected to the first outlet flow channels 31, 32, and the second fluid sub-channel 202 is connected to the second outlet flow channels 41, 42, 43. For example, the dividing member 203 is a rib oriented in the first direction D1. The fluid inlet 6 is separately connected to the first fluid sub-channel 201 and the second fluid sub-channel 202. Separating the cooling fluid flowing to the first outlet flow channels and the cooling fluid flowing to the second outlet flow channels allows different fluid flow speeds to be achieved, so as to adapt to different requirements, thus making the connector assembly and the electric drive system more flexible.

In other examples, outlet dimensions of the first outlet flow channels 31, 32 and the second outlet flow channels 41, 42, 43 can be varied according to different requirements, so as to provide different fluid flow speeds. This further increases the flexibility of the connector assembly and the system.

As a result of integrating the fluid channel, the connector assembly described above is able to guide cooling fluid directly to the electric connector connection terminals and to the gear meshing region of the speed reducer, thus integrating conduction, cooling and lubrication functions in a single component, and providing higher cooling efficiency and lubricating efficiency. In addition, the connector assembly is structurally simple and highly flexible, with a small volume and light weight.

The electric drive system provided in the present disclosure comprises the connector assembly 100 described above. It should be understood that the electric drive system of the present disclosure also has the advantages described above in relation to the connector assembly.

The present disclosure also provides a vehicle, comprising the electric drive system described above. The vehicle may be an electrified vehicle, for example, a battery electric vehicle (BEV), a hybrid electric vehicle (HEV), a plug-in hybrid electric vehicle (PHEV), a range-extended EV, or a fuel cell electric vehicle (FCEV). The vehicle may also be a hydrogen-powered vehicle. It should be understood that the vehicle of the present disclosure also has the advantages described above in relation to the connector assembly.

In addition, the technical features disclosed above are not limited to combinations of the disclosed features with other features, and those skilled in the art could combine technical features in other ways according to the objective of the invention, to realize the objective of the present disclosure.

## Claims

1. A connector assembly (100) for an electric drive system, the connector assembly comprising:
a plurality of busbars (11, 12, 13), each of the plurality of busbars having a first part extending in a first direction (D1) and an electric connection terminal (110, 120, 130);
a first insulating component (1), the first parts of the plurality of busbars being at least partially arranged in the first insulating component (1) in a mutually insulated manner; and
a fluid channel (2), arranged on the first insulating component (1) and capable of guiding a cooling fluid from a cooling system of the electric drive system.

2. The connector assembly according to claim 1, wherein
the connector assembly further comprises multiple first outlet flow channels (31, 32), which are arranged on the first insulating component (1) and in fluid communication with the fluid channel (2), and able to guide the cooling fluid to a speed reducer cavity (3) of the electric drive system, so as to perform lubrication and/or cooling.

3. The connector assembly according to claim 1 or 2, wherein
the connector assembly further comprises a plurality of second outlet flow channels (41, 42, 43), which are arranged on the first insulating component (1) and in fluid communication with the fluid channel (2), and able to guide the cooling fluid to positions where the electric connection terminals (110, 120, 130) are connected to stator terminals of the electric drive system.

4. The connector assembly according to any one of the claims 1 to 3, wherein
the fluid channel (2) extends in the first direction (D1).

5. The connector assembly according to claim 2, wherein
each of the plurality of first outlet flow channels (31, 32) is configured to guide the cooling fluid to flow towards a gear meshing region of a speed reducer of the electric drive system.

6. The connector assembly according to claim 5, wherein
the connector assembly further comprises guide tubes, which are connected to the corresponding first outlet flow channels (31, 32) and extend to the gear meshing region.

7. The connector assembly according to any one of the preceding claims, wherein
the connector assembly further comprises a fluid inlet (6) arranged on the first insulating component (1).

8. The connector assembly according to any one of the preceding claims, wherein
the fluid channel (2) comprises, in the first direction (D1), a first portion (21), a second portion (22), and a ramp portion (23) between the first portion and the second portion.

9. The connector assembly according to the claims 2 and 3, wherein
the fluid channel (2) comprises a first fluid sub-channel (201) and a second fluid sub-channel (202) which are separated from one another by a dividing member (203); the first fluid sub-channel (201) is in communication with the first outlet flow channels (31, 32), and the second fluid sub-channel (202) is in communication with the second outlet flow channels (41, 42, 43).

10. The connector assembly according to claim 9, wherein
the dividing member (203) is a rib oriented in the first direction (D1).

11. The connector assembly according to any one of the preceding claims, wherein
the first insulating component (1) is provided with a plurality of busbar channels (51, 52, 53) which are separate from one another, the plurality of busbar channels being stacked parallel to each other.

12. The connector assembly according to claim 11, wherein
the fluid channel (2) is arranged above the plurality of busbar channels (51, 52, 53).

13. The connector assembly according to any one of the preceding claims, wherein
each of the plurality of busbars (11, 12, 13) also has a second part extending in a second direction (D2) different from the first direction (D1);
the connector assembly (100) further comprises a second insulating component (8) connected to the first insulating component (1), and the second parts of the plurality of busbars (11, 12, 13) are at least partially arranged in the second insulating component (8) in a mutually insulated manner;
the connector assembly (100) further comprises a sealing member (7) which is arranged on the second insulating component (8) near the junction of the first insulating component (1) and the second insulating component (8).

14. An electric drive system, comprising the connector assembly according to any one of the preceding claims.

15. An electric drive system, comprising:
a speed reducer cavity (3);
a controller cavity (4); and
the connector assembly according to claim 13,
wherein the sealing member (7) seals the controller cavity (4) with respect to the speed reducer cavity (3).
